# EUROPÄISCHE PATENTANMELDUNG

(11) **EP 1 837 149 A1**
(43) Veröffentlichungstag der Anmeldung: **26.09.2007**
(21) Anmeldenummer: 07104419.2
(22) Anmeldetag: 19.03.2007
(51) Int. Cl.: B29C 45/14, H03K 17/95

(54) **Verfahren zum Herstellen eines Näherungsschalters sowie nach dem Verfahren gefertigter Näherungsschalter**

(30) Priorität: 21.03.2006 DE 102006012792
(71) Anmelder: Werner Turck GmbH & Co. KG, D-58553 Halver (DE)
(72) Erfinder: Allemann, Frédéric, 2822 Courroux (CH); Schaffner, Norbert, 2854 Bassecourt (CH); Steullet, Pierre Andre, 2800 Delémont (CH)
(74) Vertreter: Grundmann, Dirk

(57) **Zusammenfassung**

Die Erfindung betrifft ein Verfahren zum Herstellen eines Näherungsschalters, wobei durch Umspritzen der elektronischen Bauteile (2, 4, 5) mit einer Kunststoffmasse ein Formkörper gebildet wird, dessen Außenabmessungen den Innenabmessungen eines Gehäuses (1) entsprechen und das Formteil in das Gehäuse eingeführt und damit verbunden wird. Um die Scricntolcranzcn zu verringern, wird vorgeschlagen, dass ein Sensorkopf (2) und eine Schaltungsplatine (4) vor dem Umspritzen mit der Kunststoffmasse (6) mit im Wesentlichen flexiblen elektrischen Leitern (9) mechanisch zueinander verlagerbar miteinander verbunden werden, diese beiden Teile (2, 4) in eine Spritzgussform eingelegt werden, dort mittels Fixierelementen (S1, S2, S3, S4) in eine feste, vorbestimmte Lage zueinander und zur Wandung der Spritzgussform gehalten bzw. gebracht werden und in dieser fixierten Lage umspritzt werden.

## Beschreibung

Die Erfindung betrifft ein Verfahren zum Herstellen eines Näherungsschalters, wobei durch Umspritzen der elektronischen Bauteile mit einer Kunststoffmasse ein Formkörper gebildet wird, dessen Außenabmessungen den Innenabmessungen eines Gehäuses entsprechen und das Formteil in das Gehäuse eingeführt und damit verbunden wird. Die Erfindung betrifft darüber hinaus einen nach dem Verfahren hergestellten Näherungsschalter.

Ein Näherungsschalter, dessen elektronische Bauelemente bei weiterhin zugänglichen Anschlusselementen zumindest großteils mit Kunststoffmasse umspritzt sind, wobei die die elektronischen Bauteile umgebende Kunststoffmasse einen festen Formkörper bildet, ist aus der DE 29724696 U1 vorbekannt. Der feste Formkörper ist dort zumindest teilweise in ein Hülsenelement einführbar und wird in einem ersten Arbeitsschritt durch Umspritzen der elektronischen Bauteile mit einer Kunststoffmasse gefertigt.

Aus der DE 10121776 ist es bekannt, eine Trägerplatte durch Einspritzen einer Kunststoffmasse in einem Gehäuse zu befestigen.

Des Weiteren ist es bekannt, die elektronischen Bauteile mittelst einer in das Sensorgehäuse eingefüllten Vergussmasse dort zu fixieren.

Bei allen vorgenannten Verfahren besteht das Problem, die elektronischen Bauteile exakt zueinander zu positionieren, da bereits geringe Variationen im Abstand zu unterschiedlichen elektronischen Eigenschaften der Näherungsschalter führen. Geringe Änderungen in der Abstandslage der Spule zur Gehäusewandung bzw. zur Platine führen bei einem induktiven Näherungsschalter beispielsweise zu großen Änderungen im Schaltabstand. Die Einhaltung geringster Fertigungstoleranzen ist deshalb ein erstrebtes Ziel.

Der Erfindung liegt daher die Aufgabe zugrunde, Maßnahmen anzugeben, mit denen die Serientoleranzen verringert werden.

Gelöst wird die Aufgabe durch die in den Ansprüchen angegebene Erfindung, wobei jeder Anspruch eine eigenständige Lösung der Aufgabe darstellt. Der Anspruch 1 sieht zunächst und im Wesentlichen vor, dass ein Sensorkopf und eine Platine vor dem Umspritzen mit der Kunststoffmasse mit im Wesentlichen flexiblen Leitern miteinander verbunden werden. Die beiden elektronischen Bauteile, nämlich der Sensorkopf und die Platine sind dadurch mechanisch zueinander geringfügig verlagerbar, aber miteinander verbunden. Diese beiden Teile werden in eine Spritzgussform eingelegt. Die Spritzgussform besitzt Fixierelemente. Diese Fixierelemente sind bevorzugt verlagerbar und werden von Stempeln oder Stiften ausgebildet. Mit diesen Fixierelementen werden die beiden Teile in eine feste, vorbestimmte Lage zueinander und zur Wandung der Spritzgussform gehalten bzw. gebracht. Dies erfolgt beispielsweise durch Ausfahren der Stempel oder Stifte aus der Wandung der geschlossenen oder noch offenen Spitzgussform. Dabei können die beiden Bauteile geringfügig zueinander verlagert werden. Sie nehmen in der fixierten Stellung eine Position ein, die reproduzierbar ist. Somit ist eine reproduzierbare Feinjustage der Lage der einzelnen Bauteile zueinander und zur Wandung der Spritzgussform möglich. Sodann wird die Spritzgussmasse eingefüllt. Während des Einfüllens der Spritzgussmasse bleiben die Fixierelemente in ihrer die elektronischen Bauteile festhaltenden Position, so dass die Strömung bzw. der Strömungsdruck des in die Form eingespritzten Kunststoffes zu keiner Lageveränderung der elektronischen Bauteile führen kann. Jeder Formkörper, der auf diese Weise gefertigt wird, besitzt somit elektronische Bauteile, die bis auf minimierte Fertigungstoleranzen exakt an derselben Stelle zueinander und zur Wandung des Formkörpers liegen. Dies hat zur Folge, dass die elektronischen Bauteile auch nach Einfügen des Formteiles in das Sensorgehäuse in einer gleichen Positionslage zur Gehäusewandung, die aus Metall bestehen kann, liegen. Handelt es sich bei dem Näherungsschalter um einen induktiven Näherungsschalter, so ist dieser auch bündig einbaubar, denn bei den meisten bündigen, induktiven Näherungsschaltern, in denen sich eine Platine und eine oder mehrere Spulen in einem Metallgehäuse befinden, ist die Lage von Spulen zu Gehäuse und Abschirmung hochkritisch betreffend das Schaltverhalten des Schalters. Die Lage wird um so kritischer, je kleiner der Schalter wird. Das Verfahren ist aber nicht nur zur Fertigung von induktiven Näherungsschaltern, sondern auch zur Fertigung von kapazitiven Näherungsschaltern geeignet. Die Fixierelemente, die aus der Wandung der Spritzgussform ausfahrbare Stempel oder Stifte sein können, halten nicht nur den Sensorkopf, bei dem es sich um einen Spulenträger handeln kann, und die Platine in einer festen Position, sondern gegebenenfalls auch einen Schirmring oder eine Schirmhülse. Der Spulenträger kann aus Kunststoff oder Ferrit bestehen. In letzterem Fall bildet er einen Spulenkern. Die Fixierelemente können nach dem Umspritzen zurückgefahren werden. Dann ist es möglich, diesen so hergestellten Formkörper mit einer zweiten Spritzgussmasse zu umspritzen. Die erste Spritzgussmasse kann ein klarsichtiger Kunststoff sein, so dass Leuchtdioden, die auf der Platine angeordnet sind, von außen her sichtbar sind. Dieser erste, klarsichtige Kunststoffkörper bildet nach dem Zurückziehen der Stempel Kanäle aus, die in einem zweiten Umspritzungsschritt mit einem undurchsichtigen Kunststoff ausgefüllt werden. Mit diesem undurchsichtigen Kunststoff kann auch die Sensorstirnfläche gespritzt sein, so dass die Stirnfläche des Sensors, also die unmittelbare Sensorfläche, vom Formkörper selbst ausgebildet wird. Die bei Näherungsschaltern des Standes der Technik sonst erforderliche Abdeckkappe kann entfallen. Der auf diese Art gefertigte Rohling kann dann in ein rohrförmiges Gehäuse gesteckt werden. Das Rohr kann beispielsweise ein Metallrohr sein. Der Freiraum zwischen dem Rohling und der Gehäuseinnenwandung wird dann mit einer Kunststoffmasse ausgefüllt. Auch hier kann der Kunststoff im Spritzgussverfahren eingebracht werden. Es ist aber auch möglich, das Gehäuse mit einer Vergussmasse auszufüllen.

Die Erfindung betrifft darüber hinaus einen nach dem Verfahren gefertigten Näherungsschalter, bei dem wesentlich ist, dass die unmittelbare Stirnfläche des Formkörpers die Sensorfläche bildet. In diesem Näherungsschalter liegen die elektronischen Bauteile, also der Spulenträger, die Schaltungsplatine und die Schirmhülse beabstandet voneinander. Der Spulenträger ist lediglich mittels Litzen mit der Schaltungsplatine verbunden. Er besitzt einen Abstand zur Platine und zu der ihn umgebenden Schirmhülse. Die Schirmhülse besitzt auch einen Abstand zur Schaltungsplatine und zur Wandung des Sensorgehäuses.

Ein Ausführungsbeispiel der Erfindung wird nachfolgend anhand beigefügter Zeichnungen erläutert. Es zeigen:
- Fig. 1: einen Längsschnitt durch einen kopfseitigen Teil eines Sensors;
- Fig. 2: einen Schnitt gemäß der Linie II - II in Fig. 1;
- Fig. 3: einen Schnitt gemäß der Linie III - III in Fig. 1 und
- Fig. 4: ein zweites Ausführungsbeispiel in der Darstellung gemäß Fig. 1.

Die beiden in den Ausführungsbeispielen dargestellten Näherungsschalter sind induktive Näherungsschalter. Sie besitzen ein Sensorgehäuse 1, welches von einem Metallrohr ausgebildet ist. In dem Sensorgehäuse 1 steckt ein Formkörper 6, der zumindest teilweise eine Schaltungsplatine 4 umgibt und vollständig einen Spulenträger 2 und eine den Spulenträger 2 und bereichsweise die Schaltungsplatine 4 umgebende Schirmhülse 5. Das Sensorgehäuse 1 besitzt in den Ausführungsbeispielen die Form eines Rohres. Im fertig montierten Zustand ist das Rohr vollständig mit einer Spritzgussmasse oder einer anderweitigen Füllmasse, die die Platine eng umgibt, ausgefüllt.

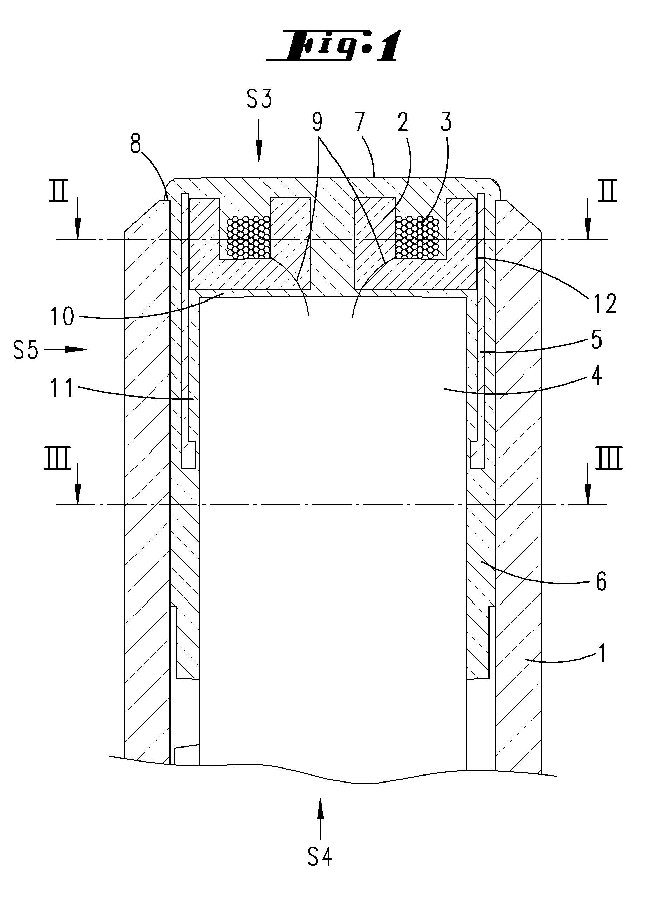

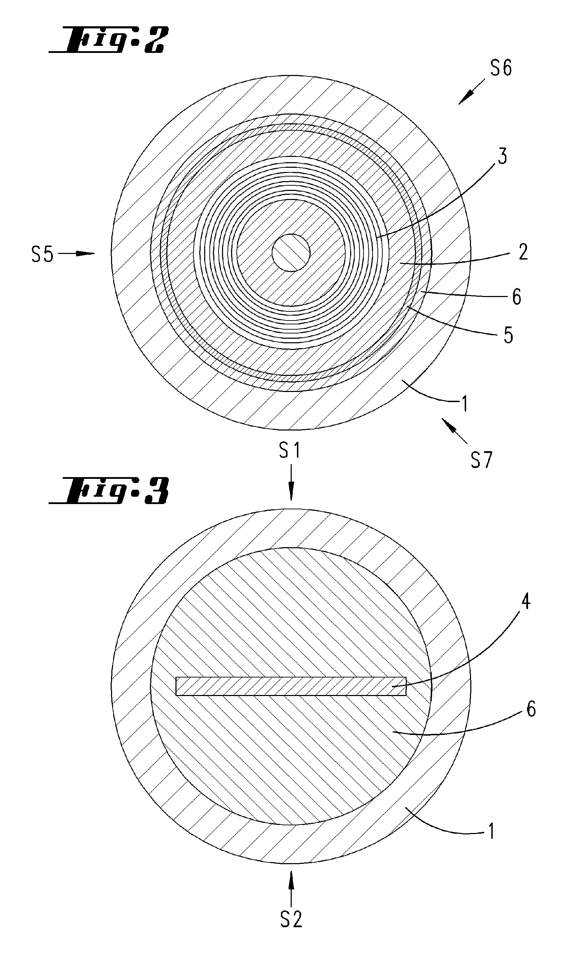

Wie der Figur 2 zu entnehmen ist, hat der Spulenträger 2 einen rotationssymmetrischen Aufbau, wobei die Rotationssymmetrieachse des Spulenträgers 2 bzw. der Schirmhülse 5 mit der Achse des Sensorgehäuses 1 zusammenfällt. Der Spulenträger 2 kann bei diesem Ausführungsbeispiel aus einem Ferritmaterial bestehen und einen kreisringförmigen, zur Stirnseite des Spulenträgers 2 hin offenen Kanal ausbilden, in welchem eine Sensorspule 3 einliegt. Mittels flexibler Leitungen, beispielsweise einem Verbindungsdraht 9, der von einer Litze gebildet ist, ist die Spule 3 elektrisch mit der Schaltungsplatine 4 verbunden. Zwischen dem Spulenträger 2 und der Schaltungsplatine 4 befindet sich ein Spaltabstand 10. Der Spulenträger 2 ist von der Schirmhülse 5 umgeben. Zwischen dem Spulenträger 2 und der Schirmhülse 5 befindet sich ebenfalls ein Spalt 12. Die Schirmhülse 5 umgibt auch den kopfseitigen Abschnitt der Schaltungsplatine 4 mit einem Abstand 11.

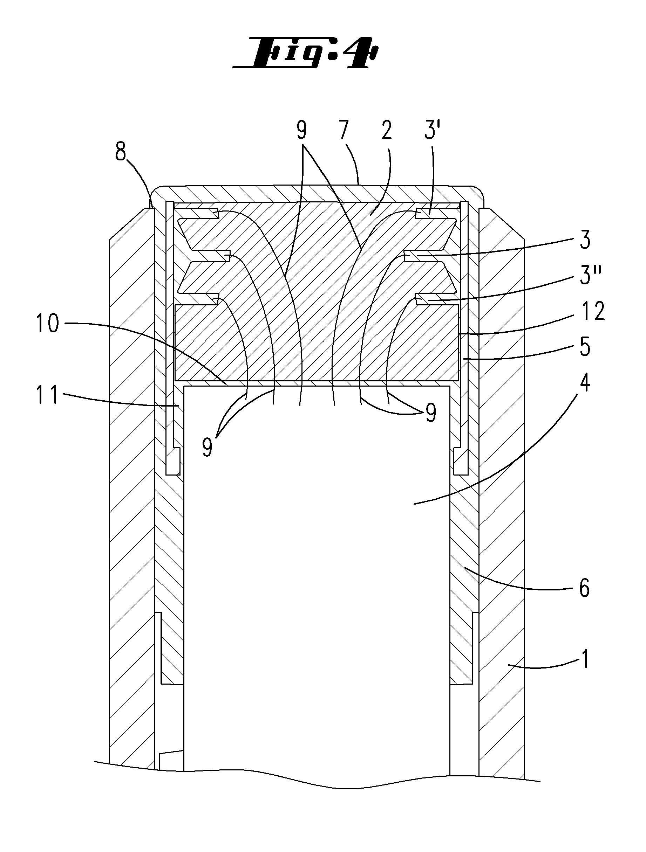

Wie aus der Figur 3 zu entnehmen ist, liegt die Platine 4 in der Mitte der Höhlung des Sensorgehäuses 1. Die Platine verläuft somit auf einer Diametralen.

Das Ausführungsbeispiel der Figur 4 unterscheidet sich im Wesentlichen nur durch die Form des Spulenträgers 2 von dem in der Figur 1 dargestellten Ausführungsbeispiel. Dort ist der Spulenträger 2 aus Kunststoff gefertigt und bildet insgesamt drei Umfangsnuten zur Aufnahme dreier Spulen 3, 3', 3", die jeweils mittels flexibler Anschlussleitungen 9 mit der Platine 4 verbunden sind, so dass im nicht zusammengebauten Zustand der Spulenträger 2 und die Schaltungsplatine 4 eine Baugruppe ausbilden, wobei die Elemente dieser Baugruppe flexibel und verlagerbar einander zugeordnet sind. Bei der Spule 3 kann es sich um eine Sendespule handeln. Die beiden Spulen 3', 3" sind Empfangsspulen, die in einer Differenzschaltung zueinander geschaltet sind.

Zur Fertigung der zuvor beschriebenen Sensoren werden der Spulenträger 2 und die mit dem Spulenträger 2 über die Verbindungsdrähte 9 verbundene Schaltungsplatine 4 und die Schirmhülse 5 in eine Spritzgussform eingelegt. Die zuvor beschriebenen Bauteile, Spulenträger 2, Schaltungsplatine 4 und Schirmhülse 5 sind gegeneinander und gegenüber der Wandung der Spritzgussform verlagerbar. Um sie in der Spritzgussform mit einem Abstand zur Wandung der Spritzgussform und mit einem Abstand gegen die jeweils anderen elektronischen Bauteile zu halten, sind Stempel oder Stifte und insbesondere Doppelstempel oder -stifte vorgesehen, die aus der Wandung der Spritzgussform ausfahren können, um die Bauteile 2, 4, 5 in Position zu bringen und während des Einspritzens des Kunststoffes in dieser Position zu halten.

Diese Fixierelemente, die bevorzugt von Stempeln ausgebildet werden, sind in den Zeichnungen als Pfeile S1 bis S7 schematisch dargestellt. So symbolisieren die Pfeile S1, S2 zwei aufeinander zu fahrbare Stempel oder Stempelgruppen, die die Platine 4 in Position halten. Zur Halterung der Platine 4 können aber noch zusätzliche Stempel vorgesehen sein, die insbesondere die Achslage der Platine definieren. In Achsrichtung wirkende Stempel sind durch die Pfeile S3, S4 symbolisiert. Mit den Pfeilen S5, S6, S7 sind Stempel symbolisch dargestellt, die die elektronischen Bauteile und insbesondere die Platine 4 oder den Schirmring 5 in der dritten Raumrichtung fixieren können.

Der Spulenträger 2 wird in der gleichen Weise in den drei Raumrichtungen durch am Spulenträger an geeigneter Stelle angreifende Stempel S1, S7 fixiert. Dabei nimmt der Spulenträger 2 eine feste Raumlage gegenüber der Wandung der Spritzgussform und der Platine 4 ein. Auch die Schirmhülse 5 wird durch geeignet geformte Stempel S1, S7 in einer festen Raumlage gegenüber der Schaltungsplatine 4, dem Spulenträger 2 und der Wandung der Spritzgussform fixiert.

Bei einer Serienfertigung wird somit jedes der zuvor genannten elektronischen Bauteile 2, 4, 5 mit Ausnahme geringfügiger Toleranzen exakt in derselben Lage positioniert.

Die so positionierten elektronischen Bauteile 2, 4, 5 werden sodann zumindest teilweise mit einer Kunststoffmasse umspritzt. Dies erfolgt dadurch, dass eine Kunststoffmasse 6 in die Spritzgussform eingebracht wird. Während es von Vorteil ist, wenn die Schirmhülse 5 und der Spulenträger 2 vollständig mit einer Kunststoffmasse 6 umspritzt sind, reicht es aus, wenn die Platine 4 lediglich teilweise von der Spritzgussmasse 6 umspritzt ist.

Mit den zuvor geschilderten Verfahrensschritten wird ein erster Formkörper ausgebildet, der nach dem Rückzug der Stempel S1, S7 Kanäle aufweist. Diese Kanäle werden in einem zweiten Spritzgussschritt mit einer zweiten Spritzgussmasse ausgefüllt. Diese Spritzgussmasse kann eine undurchsichtige Spritzgussmasse sein. Die erste Spritzgussmasse kann transparent sein, so dass auf der Platine angeordnete Leuchtdioden von außen sichtbar sind. Die Bereiche des zuerst gefertigten transparenten Körpers, durch welche die Leuchtdioden leuchten sollen, werden nicht von der undurchsichtigen Spritzgussmasse umspritzt.

Die Stirnfläche des durch das Umspritzen ausgebildeten Formkörpers 6 bildet die unmittelbare Sensorfläche 7 aus, hinter welcher sich der Spulenträger 2 befindet. Diese Sensorfläche 7 wird bevorzugt von der Kunststoffmasse des zuletzt eingespritzten Kunststoffs ausgebildet, so dass sie nicht transparent ist. Eine zusätzliche Kappenabdeckung der Stirnseite des Formkörpers ist dadurch entbehrlich geworden.

Wie den Darstellungen zu entnehmen ist, sind die Spaltzwischenräume 10, 11, 12 zwischen Spulenträger 2, Schaltungsplatine 4 und Schirmhülse 5 sowie der die Schirmhülse 5 umgebende Bereich vollständig mit Kunststoff ausgefüllt. Die einzelnen elektronischen Bauteile 2, 4, 5 liegen somit mit einem gegenseitigen Abstand zueinander im von der Spritzgussmasse 6 gebildeten Formkörper.

Im Bereich der Sensorfläche 7 bildet der Formkörper 6 eine Umfangsstufe aus, mit der der Formkörper auf einer ringförmigen Stirnseite des Sensorgehäuses 1 aufliegt. Hierdurch ist auch eine axiale Lagebestimmung des Formkörpers 6 innerhalb des Sensorgehäuses 1 gegeben. Wenn der Außendurchmesser des Formkörpers 6 im Wesentlichen exakt dem Innendurchmesser des kreiszylindrischen Sensorgehäuses 1 entspricht, kann die Montage durch ledigliches Einschieben des Formkörpers 6 in das Sensorgehäuse 1 bestehen. Der Formkörper kann dort mit geeigneten Fixiermitteln, beispielsweise einer Madenschraube oder mit Klebstoff gehalten werden.

Füllt der mit den zuvor erörterten Prozessschritten gefertigte Rohling nicht die Höhlung des rohrförmigen Sensorgehäuses 1 aus, so kann letzteres nach Montage des Rohlings mit einer Vergussmasse ausgefüllt werden.

Alle offenbarten Merkmale sind (für sich) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen.

## Patentansprüche

1. Verfahren zum Herstellen eines Näherungsschalters, wobei durch Umspritzen der elektronischen Bauteile (2, 4, 5) mit einer Kunststoffmasse ein Formkörper gebildet wird, dessen Außenabmessungen den Innenabmessungen eines Gehäuses (1) entsprechen und das Formteil in das Gehäuse eingeführt und damit verbunden wird, **dadurch gekennzeichnet, dass** ein Sensorkopf (2) und eine Schaltungsplatine (4) vor dem Umspritzen mit der Kunststoffmasse (6) mit im Wesentlichen flexiblen elektrischen Leitern (9) mechanisch zueinander verlagerbar miteinander verbunden werden, diese beiden Teile (2, 4) in eine Spritzgussform eingelegt werden, dort mittels Fixierelementen (S1, S2, S3, S4) in eine feste, vorbestimmte Lage zueinander und zur Wandung der Spritzgussform gehalten bzw. gebracht werden und in dieser fixierten Lage umspritzt werden.

2. Verfahren nach Anspruch 1 oder insbesondere danach, **dadurch gekennzeichnet, dass** die Fixierelemente (S1, S2, S3, S4, S5, S6, S7) aus der Wandung der Spritzgussform ausfahrbare Stempel sind, die den Sensorkopf (2), die Platine (4) und gegebenenfalls einen Schirmring oder eine Schirmhülse (5) in die vorbestimmte Lage bringen bzw. dort während des Umspritzens halten.

3. Verfahren nach einem oder mehreren der vorangehenden Ansprüche oder insbesondere danach, **dadurch gekennzeichnet, dass** der Näherungsschalter ein induktiver Näherungsschalter ist und der Sensorkopf (2) ein mindestens eine Spule aufweisender Spulenkörper oder Spulenkern ist.

4. Verfahren nach einem oder mehreren der vorangehenden Ansprüche oder insbesondere danach, **dadurch gekennzeichnet, dass** die Fixierelemente (S1, S2, S3, S4, S5, S6, S7) nach dem Umspritzen zurückgefahren werden und der Formkörper (6) mit einer zweiten Spritzgussmasse umspritzt wird.

5. Nach dem Verfahren gemäß einem oder mehreren der vorangehenden Ansprüche oder insbesondere danach gefertigter Näherungsschalter, **gekennzeichnet durch** ein im Wesentlichen zylindrisches Gehäuse (1) und einen im Wesentlichen zylindrischen, die elektronischen Bauelemente (2, 4, 5) tragenden Formkörper, wobei die unmittelbare Stirnfläche (7) des Formkörpers (6) die Sensorfläche bildet.

6. Näherungsschalter nach Anspruch 5 oder insbesondere danach, **dadurch gekennzeichnet, dass** die elektronischen Bauelemente (2, 4) mit flexiblen Drähten (9), insbesondere Litzen miteinander verbunden sind.

7. Näherungsschalter nach einem oder mehreren der Ansprüche 5 oder 6 oder insbesondere danach, **dadurch gekennzeichnet, dass** der Spulenträger (2) und die Schirmhülse (5) allseitig umspritzt sind.
